# EUROPEAN PATENT APPLICATION

(11) **EP 2 448 381 A1**
(43) Date of publication of application: **02.05.2012**
(21) Application number: 11185634.0
(22) Date of filing: 18.10.2011
(51) Int. Cl.: H05K 3/00, H05K 3/30, H05K 3/42

(54) **Wiring board having a plurality of vias**

(30) Priority: 27.10.2010 JP 2010240281
(71) Applicant: Fujitsu Limited, Kawasaki-shi, Kanagawa 211-8588 (JP)
(72) Inventor: Sugane, Mitsuhiko, Kawasaki-shi, Kanagawa 211-8588 (JP); Mukoyama, Takahide, Kawasaki-shi, Kanagawa 211-8588 (JP); Yamada, Tetsuro, Kawasaki-shi, Kanagawa 211-8588 (JP); Hiroshima, Yoshiyuki, Kawasaki-shi, Kanagawa 211-8588 (JP); Ooi, Takahiro, Kawasaki-shi, Kanagawa 211-8588 (JP); Kobayashi, Midori, Kawasaki-shi, Kanagawa 211-8588 (JP); Matsui, Akiko, Kawasaki-shi, Kanagawa 211-8588 (JP)
(74) Representative: Fenlon, Christine Lesley

(57) **Abstract**

A wiring board unit includes a connector having a plurality of terminals; and a wiring board on which the connector is mounted. The wiring board includes a first wiring pattern provided on a first wiring layer, a second wiring pattern provided on a second wiring layer at a position shallower than the first wiring layer, a first via formed in a first recess having a first depth, the first via being in contact with the first wiring pattern, and a second via formed in a second recess having a second depth that is smaller than the first depth, the second via being in contact with the second wiring pattern.

## Description

### CROSS-REFERENCE TO RELATED APPLICATIONS

This application is based upon and claims the benefit of priority of the prior Japanese Patent Application No. 2010-240281, filed on October 27, 2010 the entire contents of which are incorporated herein by reference.

### FIELD

The present invention relates to a wiring board unit, a network apparatus, and a method for manufacturing a wiring board unit.

### BACKGROUND

In an example of a multilayered printed wiring board including wiring layers according to the related art, a through hole is provided to transmit signals between the wiring layers and a via is formed by plating the inner surface of the through hole with a conductive material.

High-frequency signals are largely affected by the wiring lengths of transmission paths. Therefore, the wiring lengths on the wiring board are designed such that the signals are not excessively affected.

Since the plating serves as a part of the wiring, the plating area is preferably reduced to reduce the influence on the signals.

As an example of a method for reducing the plating area, a method (hereinafter referred to as a back drilling method) is known in which an unnecessary part of the plated via is removed by a drill bit.

Related art is disclosed in Japanese Laid-open Patent Publication No. 2003-521116, Japanese Laid-open Patent Publication No. 2002-198461, Japanese Laid-open Patent Publication No. 08-008538, and Japanese Laid-open Patent Publication No. 2001-217540.

The back drilling method has a low processing precision, and there is a possibility that a plating burr will be generated at the via.

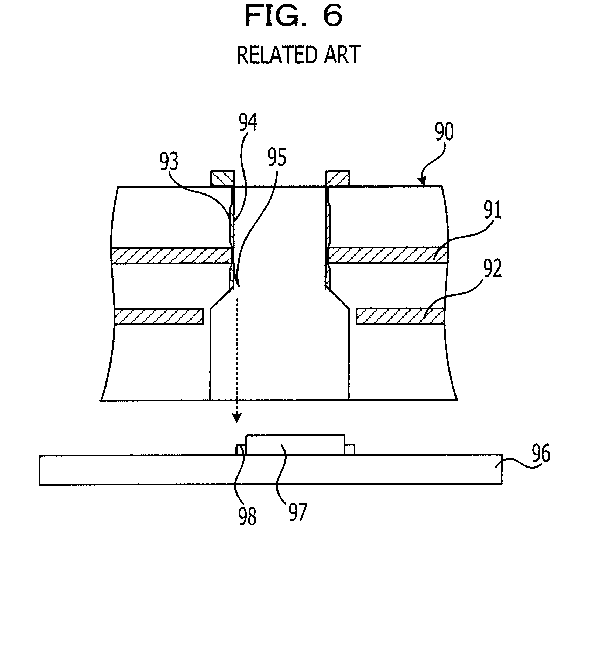

FIG. 6 illustrates an example of a wiring board formed by the back drilling method.

A wiring board 90 is a multilayered wiring board, and includes a wiring pattern 91 and a wiring pattern 92 arranged on different wiring layers.

A hole 93 is drilled in the wiring board 90. A via 94 is formed by plating the inner surface of the hole 93. The plating is electrically connected to the wiring pattern 91. A lower portion of the via 94 is removed by a drill bit. As a result of this drilling process, a plating burr 95 is formed on a part of the plating.

FIG. 6 also illustrates a wiring board 96 arranged below the wiring board 90. A semiconductor integrated circuit 97 including a plurality of terminals 98 is arranged on the wiring board 96.

When, for example, the plating burr 95 falls, the plating burr 95 serves as conductive foreign matter. If the conductive foreign matter comes into contact with the terminals 98, the terminals 98 will be short-circuited, which leads to a failure of the semiconductor integrated circuit 97.

### SUMMARY

According to an embodiment of a first aspect of the invention, a wiring board unit includes a connector having a plurality of terminals; and a wiring board on which the connector is mounted. The wiring board includes a first wiring pattern provided on a first wiring layer, a second wiring pattern provided on a second wiring layer at a position shallower than the first wiring layer, a first via formed in a first recess having a first depth, the first via being in contact with the first wiring pattern, and a second via formed in a second recess having a second depth that is smaller than the first depth, the second via being in contact with the second wiring pattern.

**[0014A]** According to an embodiment of a second aspect of the invention, a network apparatus comprises a wiring board unit including a connector having a plurality of terminals and a wiring board on which the connector is mounted; and a housing that houses the wiring board unit, wherein the wiring board includes a first wiring pattern provided on a first wiring layer, a second wiring pattern provided on a second wiring layer at a position shallower than the first wiring layer, a first via formed in a first recess having a first depth, the first via being in contact with the first wiring pattern, and a second via formed in a second recess having a second depth that is smaller than the first depth, the second via being in contact with the second wiring pattern, wherein the first via is provided with a conductive member having a third recess that extends to a wiring layer at a position shallower than the second depth, wherein the second via is provided with a fourth recess that extends to the same wiring layer as the wiring layer to which the third recess extends, and wherein the terminals are electrically connected to a side portion of the third recess and a side portion of the fourth recess.

Advantages of the invention will be apparent from the description below, as well as the elements and combinations particularly pointed out in the claims.

It is to be understood that both the foregoing general description and the following detailed description are exemplary and explanatory and are not restrictive of the invention, as claimed.

### BRIEF DESCRIPTION OF DRAWINGS

FIG. 1 illustrates a network apparatus according to an embodiment;

FIG. 2 is a perspective view of an example of a press-fit connector;

FIG. 3 is a sectional side view of a wiring board unit according to the embodiment;

FIG. 4 is an exploded perspective view of the wiring board unit according to the embodiment;

FIGs. 5A to 5E illustrate a method for manufacturing the wiring board unit; and

FIG. 6 illustrates an example of a wiring board formed by a back drilling method.

### DETAILED DESCRIPTION OF THE EMBODIMENTS

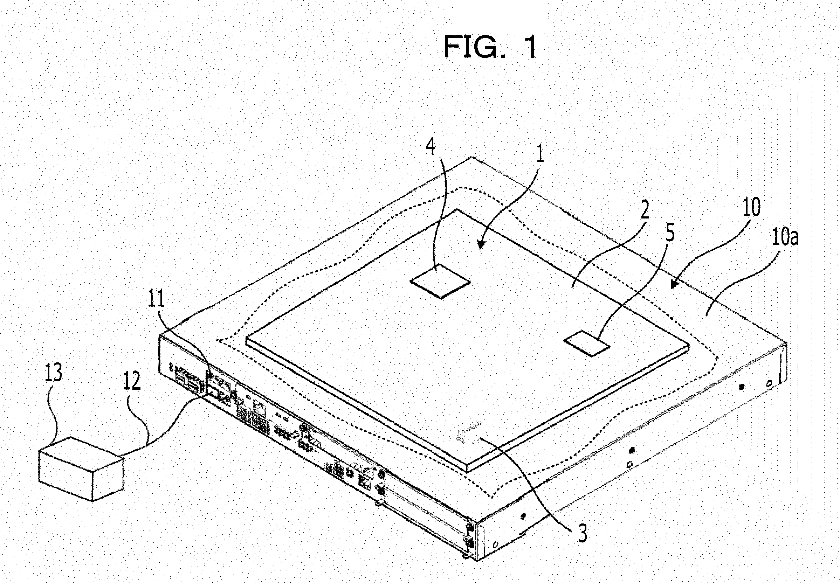

An embodiment will be described in detail with reference to the drawings. FIG. 1 illustrates a network apparatus 10 according to the embodiment. The network apparatus 10 is a router, and includes a plurality of 10/100/1000 BASE-T ports 11. An end of a local area network (LAN) cable 12 is inserted into one of the ports 11, and the other end of the cable 12 is inserted into a HUB 13. Thus, the network apparatus 10 is connected to the HUB 13.

The network apparatus 10 includes a housing 10a and a wiring board unit 1 disposed in the housing 10a. The wiring board unit 1 includes a printed wiring board 2. A press-fit connector 3, a central processing unit (CPU) 4, and a memory 5 are mounted on the printed wiring board 2.

The CPU 4 controls the entire network apparatus 10. The memory 5 stores at least a part of a program to be executed by the CPU 4. In the present embodiment, a router is explained as an example of a network apparatus on which the wiring board unit 1 is mounted. However, the product on which the wiring board unit 1 may be mounted is not limited to a router. The wiring board unit 1 may instead be mounted on other server systems or network system devices, such as a switch or a wireless LAN.

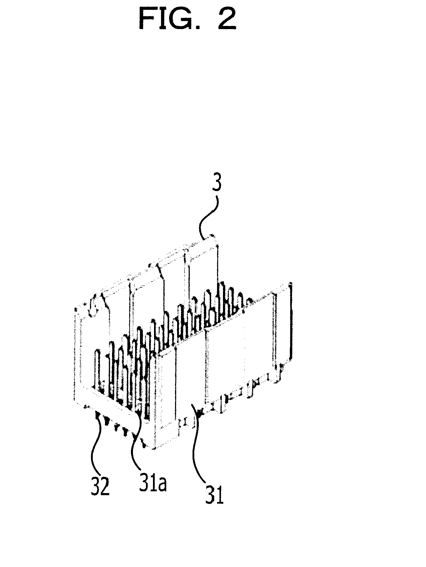

FIG. 2 is a perspective view of an example of a press-fit connector.

The press-fit connector 3 includes a connector body 31 and a plurality of connector pins 32. The connector body 31 includes a flat portion 31a and is formed of resin or the like. The connector pins 32 are supported by the flat portion 31a of the connector body 31 and are arranged so as to extend perpendicular to the front surface (top surface in FIG. 2) and the back surface (bottom surface in FIG. 2) of the flat portion 31a.

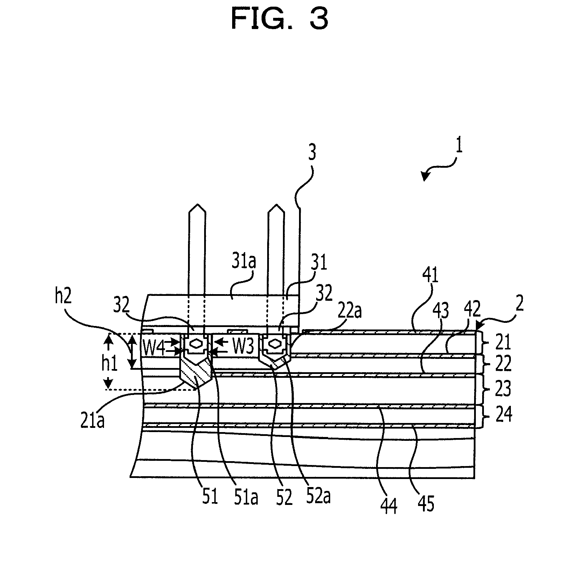

FIG. 3 is a sectional side view of the wiring board unit 1 according to the embodiment.

The printed wiring board 2 is a multilayer board, and includes wiring layers 21 to 24 in FIG. 3. The thicknesses of the wiring layers 21 to 24 are, for example, about 0.1 mm to 0.15 mm. The thickness of the printed wiring board 2 is, for example, about 6 mm. In FIG. 3, layers other than the wiring layers 21 to 24 are not illustrated.

Wiring patterns 41 to 45 through which signals are transmitted are provided on the wiring layers 21 to 24. A hollow part 21a (first recess) and a hollow part 22a (second recess), each of which has a bottom, are formed in the printed wiring board 2. The hollow parts 21a and 22a are examples of first hollow parts. The inner surfaces of the hollow parts 21a and 22a are plated with, for example, copper (Cu), so that a via (first via) 51 and a via (second via) 52 are formed. The via 51 extends through the wiring layers 21 and 22. The via 52 extends through the wiring layer 21.

The depth h1 of the via 51, which is a distance between the surface of the printed wiring board 2 and the deepest point of the via 51, is, for example, about 0.2 mm to 0.44 mm. The depth h2 of the via 52, which is a distance between the surface of the printed wiring board 2 and the deepest point of the via 52, is, for example, about 0.1 mm to 0.29 mm.

Portions of the vias 51 and 52 that have the maximum radius have the same width W3, which is, for example, about 1.0 mm. The via 51 and the wiring pattern 43 (first wiring pattern) are electrically connected to each other. The via 52 and the wiring pattern 42 (second wiring pattern) are electrically connected to each other.

Hollow parts 51a and 52a are formed in the vias 51 and 52, respectively, such that the hollow parts 51a and 52a extend to the same wiring layer (the wiring layer 22 in the present embodiment). In the present embodiment, the hollow parts 51a and 52a have the same depth. The hollow part 51a (third recess) and the hollow part 52a (fourth recess) are examples of second hollow parts. The width W4 of portions of the hollow parts 51a and 52a that have the maximum radius is determined by the width of the connector pins 32, and is set to, for example, about 0.55 mm.

Certain gaps are provided between the connector pins 32 and bottom portions of the hollow parts 51a and 52a. The positional relationship between the wiring layers and the hollow parts 51a and 52a is as follows.

That is, a side portion of the hollow part 51a formed in the via 51 and a side portion of the hollow part 52a formed in the via 52 are positioned in the wiring layer 21. Void spaces defined by the hollow parts 51a and 52a in the vias 51 and 52, respectively, form via holes.

The side portion of the hollow part 51a formed in the via 51 and the side portion and a bottom portion of the hollow part 52a formed in the via 52 are positioned in the wiring layer 22. The side portion and a bottom portion of the hollow part 51a formed in the via 51 are positioned in the wiring layer 23.

End portions of the connector pins 32 at one end thereof are press-fitted to the hollow parts 51a and 52a. End portions of the connector pins 32 at the other end thereof are connected to terminals of a connector. The connector pins 32 are press-fitted to the hollow parts 51a and 52a such that the side portions of the hollow parts 51a and 52a are in contact with the connector pins 32 so as to support the connector pins 32. Thus, in FIG. 3, the left connector pin 32 is electrically connected to the wiring pattern 43 through the via 51. Similarly, the right connector pin 32 is electrically connected to the wiring pattern 42 through the via 52.

Owing to the press-fitting process, the connector pins 32 are electrically connected to the vias 51 and 52 without using solder. Therefore, signals may be transmitted at a high speed. In the wiring board unit 1, the vias 51 and 52 are not open at the bottom of the printed wiring board 2. Accordingly, for example, residual chips generated when the hollow parts 51a and 52a are formed by a cutting process are prevented from falling from the printed wiring board 2. Accordingly, when the wiring board unit 1 is mounted on another wiring board, short circuiting at the wiring board on which the wiring board unit 1 is mounted may be prevented. Thus, the reliability of the entire system including the wiring board unit may be increased.

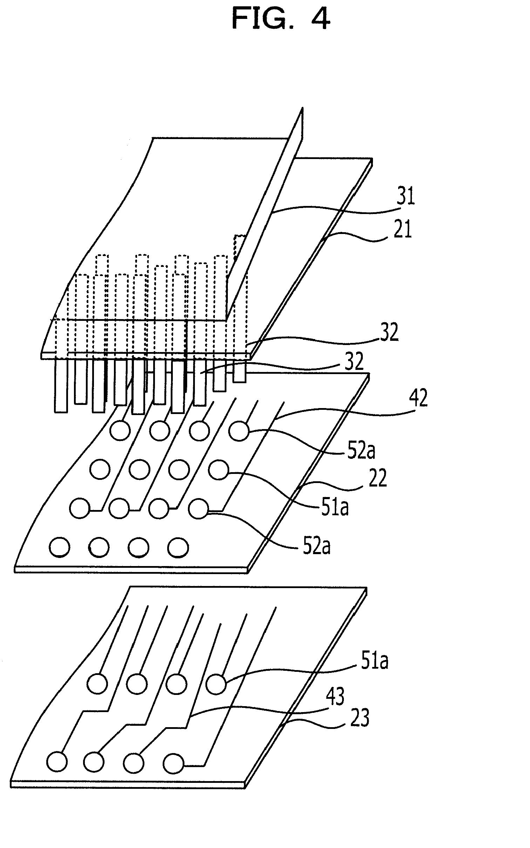

FIG. 4 is an exploded perspective view of the wiring board unit 1 according to the embodiment.

FIG. 4 illustrates the wiring layers 21 to 23. As illustrated in FIG. 4, in the wiring board unit 1, a portion of the wiring layer 23 that is positioned below each hollow part 52a is not cut. Therefore, the wiring pattern 43 may be arranged below each hollow part 52a and formed such that the wiring pattern 43 does not go around the area below each hollow part 52a. Thus, restrictions on the wiring caused by the vias 51 and 52 may be reduced, and the design versatility may be increased.

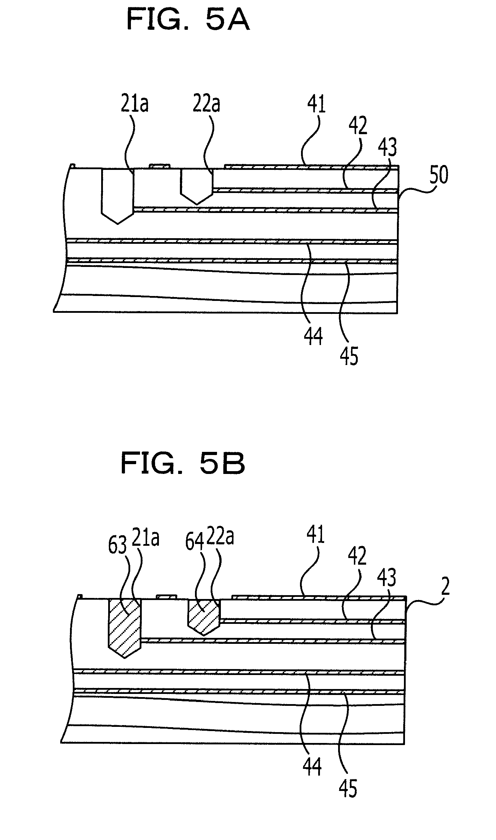

A method for manufacturing the wiring board unit 1 will now be described. FIGs. 5A to 5E illustrate a method for manufacturing the wiring board unit 1.

First Hole Forming Step

A printed wiring board 50 in which the wiring patterns 41 to 45 are arranged on the respective wiring layers is prepared.

After that, as illustrated in FIG. 5A, the hollow part 21a (first recess) and the hollow part 22a (second recess), which have a diameter of about 1 mm, are drilled in the prepared printed wiring board 50 at positions corresponding to the wiring patterns on the respective wiring layers. Thus, the printed wiring board 2 is formed. The depths of the hollow parts 21a and 22a are adjusted in accordance with the positions of the wiring patterns on the respective wiring layers.

Plating Step

As illustrated in FIG. 5B, a plating process is performed to fill the bottom and side portions of the hollow parts 21a and 22a with copper by electroless copper plating and electrolytic copper plating. After that, through-hole plating portions 63 and 64 are formed so as to entirely fill the hollow parts 21a and 22a. Thus, a so-called cap plating structure is formed in which the hollow parts 21a and 22a are entirely filled with the plating material.

Second Hole Forming Step

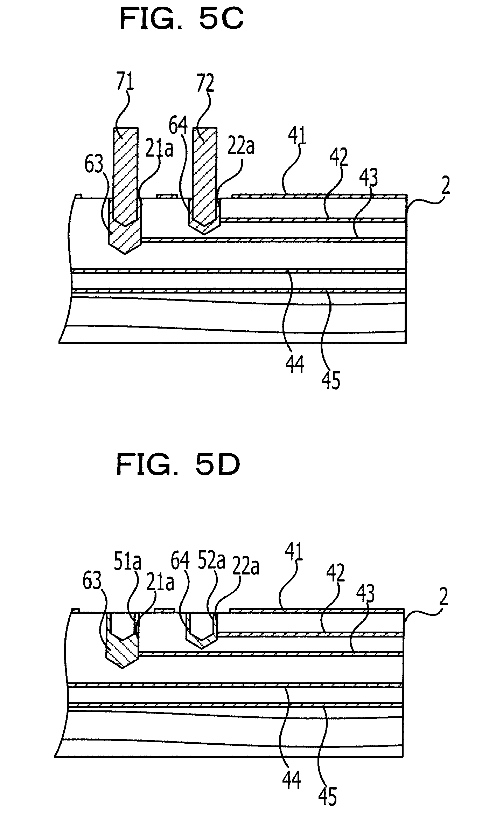

The hollow parts 51a and 52a are formed. More specifically, as illustrated in FIG. 5C, the through-hole plating portions 63 and 64, which are formed so as to fill the hollow parts 21a and 22a, respectively, are partially cut by using drills 71 and 72 having a diameter (for example, 0.55 mm) smaller than that of drills used to form the hollow parts 21a and 22a in the first hole forming step. Thus, the hollow part 51a (third recess) and the hollow part 52a (fourth recess) are formed in the through-hole plating portions 63 and 64, respectively. In this step, the depths of the hollow parts 51a and 52a are set such that the bottom portions of the hollow parts 51a and 52a are not deeper than the bottom portions of the through-hole plating portions 63 and 64 but are deeper than the positions at which the bottom portions of the connector pins 32 (the length of the connector pins 32) are to be located. FIG. 5D illustrates the thus-formed hollow parts 51a and 52a.

Since the depths of the hollow parts 51a and 52a are set as described above, the connector pins 32 are prevented from coming into contact with the bottom surfaces of the plating portions and being bent when the connector pins 32 are press-fitted into the hollow parts 51a and 52a. When a plurality of connector pins 32 are provided as in the press-fit connector 3, the hollow parts 51a and 52a are preferably positioned at the centers of lands.

The hollow parts 51a and 52a are formed at desired positions by, for example, the following positioning method. That is, a pad-shaped mark or non-through hole that serves as a positioning reference is formed on the printed wiring board 2.

The size and position of each connector pin 32 on the press-fit connector 3 are measured based on the positioning reference. A drilling machine having a charge coupled device (CCD) camera or the like is used for the measurement. Lands of the through-hole plating portions 63 and 64 are provided at positions determined by the size measurement performed by the CCD camera. The shapes of the lands are determined, and the centers of the lands are calculated. After that, the hole forming process is performed.

Connector Mounting Step

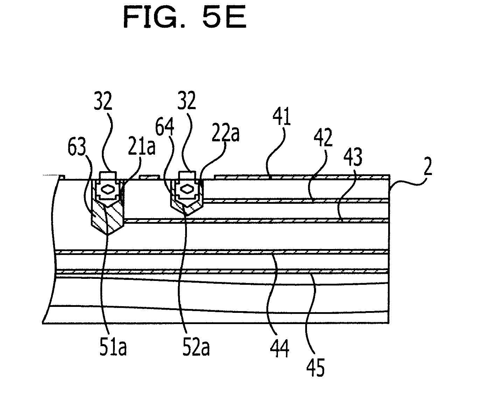

As illustrated in FIG. 5E, the connector pins 32 on the press-fit connector 3 are press-fitted into the hollow parts 51a and 52a. Thus, the press-fit connector 3 is fixed to the printed wiring board 2. As a result, the side portions of the hollow parts 51a and 52a come into contact with the connector pins 32 so as to support the connector pins 32. Accordingly, the wiring patterns are electrically connected to the connector pins 32 through the through-hole plating portions 63 and 64.

The CPU 4 and the memory 5 are mounted in a desired step.

The wiring board unit 1 is manufactured by the above-described steps. As described above, according to the manufacturing method of the present embodiment, the hollow parts 51a and 52a are formed by drilling holes in the through-hole plating portions 63 and 64, respectively. Therefore, the hollow parts 51a and 52a may be formed with high processing accuracy. Accordingly, the printed wiring board 2 in which impedance matching between the hollow parts 51a and 52a is improved may be provided.

More specifically, connectors, such as press-fit connectors, that transmit high-frequency signals preferably have short connector pins with small diameters to suppress noise. Therefore, there has been a tendency to reduce the lengths and diameters of the connector pins, and the accuracy of the vias that receive the connector pins is desirably increased in accordance with such a tendency. When, for example, the ratio of the depth of the hollow parts to the diameter of the holes before the through-hole plating portions are formed (aspect ratio) exceeds 10, it may become difficult to form through holes in a uniform shape, or it may even become difficult to form the through holes. For example, when the thickness of the printed wiring board is 6 mm or more and the drill diameter is 0.5 mm or less, the aspect ratio of the through holes to which the press-fit connector is mounted is 12 or more.

According to the manufacturing method of the present embodiment, the yield may be increased and the hollow parts 51a and 52a having a uniform shape may be formed. Therefore, the hollow parts 51a and 52a are not easily damaged and plating burrs are not easily generated when the press-fit connector 3 is replaced.

In addition, compared to the back drilling method, the area of the portions of the printed wiring board 2 that are cut is reduced. Therefore, the wiring area and the design versatility are not largely reduced. In other words, since no vias are formed in the wiring layers under the through-hole plating portions 63 and 64, signal patterns may be arranged on these wiring layers. As a result, the wiring capacity may be increased.

When, for example, the hollow parts of the non-through holes are formed by etching unlike the above-described method, there is a possibility that sulfuric acid/hydrogen peroxide/water mixture, which is often used as a processing solvent after the process of plating the inner surfaces of the hollow parts, will remain at the bottom of the holes as a residue. If sulfuric acid/hydrogen peroxide/water mixture remains as a residue, three is a possibility that the plating portions will be corroded by sulfuric acid/hydrogen peroxide/water mixture and the through holes will be disconnected, which leads to a failure. In contrast, according to the above-described method, the hollow parts 51a and 52a are formed without using an etching process. Therefore, the occurrence of disconnection of the through holes may be reduced.

In addition, according to the above-described manufacturing method, since back drilling is not performed, plating burrs are not generated when the hollow parts 51a and 52a are formed.

All examples and conditional language recited herein are intended for pedagogical purposes to aid the reader in understanding the invention and the concepts contributed by the inventor to furthering the art, and are to be construed as being without limitation to such specifically recited examples and conditions, nor does the organization of such examples in the specification relate to a showing of the superiority and inferiority of the invention. Although the embodiment of the present invention has been described in detail, it should be understood that the various changes, substitutions, and alterations could be made hereto without departing from the spirit and scope of the invention.

## Claims

1. A wiring board unit comprising:
a connector having a plurality of terminals; and
a wiring board on which the connector is mounted,
wherein the wiring board includes
a first wiring pattern provided on a first wiring layer,
a second wiring pattern provided on a second wiring layer at a position shallower than the first wiring layer,
a first via formed in a first recess having a first depth, the first via being in contact with the first wiring pattern, and
a second via formed in a second recess having a second depth that is smaller than the first depth, the second via being in contact with the second wiring pattern,
wherein the first via is provided with a conductive member having a third recess that extends to a wiring layer at a position shallower than the second depth,
wherein the second via is provided with a conductive member having a fourth recess that extends to the same wiring layer as the wiring layer to which the third recess extends, and
wherein the terminals are electrically connected to a side portion of the third recess and a side portion of the fourth recess.

2. The wiring board unit according to Claim 1,
wherein the first depth of the first recess corresponds to the position of the first wiring pattern, and
wherein the second depth of the second recess corresponds to the position of the second wiring pattern.

3. The wiring board unit according to Claim 1 or 2,
wherein the terminals are separated from a bottom portion of the third recess and a bottom portion of the fourth recess.

4. A network apparatus comprising:
a wiring board unit as claimed in claim 1, 2 or 3; and
a housing that houses the wiring board unit.

5. A method for manufacturing a wiring board unit on which a connector is mounted, the method comprising:
forming a first recess and a second recess in a wiring board in which a first wiring layer having a first wiring pattern formed thereon and a second wiring layer having a second wiring pattern formed thereon are stacked, the first recess being in contact with the first wiring pattern and the second recess being shallower than the first recess and being in contact with the second wiring pattern;
filling the first recess and the second recess with conductive members;
respectively forming a third recess and a fourth recess in the conductive members with which the first recess and the second recess are filled, the third recess and the fourth recess extending to the same wiring layer; and
inserting terminals of the connector into the third recess and the fourth recess.
